Europäisches Patentamt

(19) European Patent Office

Office européen des brevets

(11) Publication number: **0 026 325**
A1

(12) # EUROPEAN PATENT APPLICATION

(21) Application number: 80105081.6

(22) Date of filing: 27.08.80

(51) Int. Cl.³: **C 30 B 19/06**

(30) Priority: 28.09.79 US 79772

(43) Date of publication of application:
08.04.81 Bulletin 81/14

(84) Designated Contracting States:
DE FR GB IT

(71) Applicant: International Business Machines
Corporation

Armonk, N.Y. 10504(US)

(72) Inventor: Grandia, Johannes
1569 Monteval Lane
San Jose California 95120(US)

(72) Inventor: McChesney, William George
517 Blossom Hill Road
Log Gatos California 95030(US)

(72) Inventor: Santini, Hugo Alberto Emilio
339 Bodega Way
San Jose California 95119(US)

(72) Inventor: Turk, Harold Leon
1623 Puerto Vallarta Drive
San JOse California 95120(US)

(74) Representative: Lewis, Alan J.
IBM United Kingdom Patent Operations Hursley Park
Winchester, Hants, S021 2JN(GB)

(54) A wafer holder for use in growing liquid phase epitaxial films on wafers.

(57) A wafer holder for liquid phase epitaxial (LPE) film growth
is shown. The holder (10) has two legs (12, 14) to which the top
ring (16) is connected. The ring (16) has holding means (19) so
that it can hold one wafer (18) or two wafers (18, 20) back-to-
back. The leg (14) extends vertically below the ring (16) and a
second ring (21) having holding means (25) for a pair of wafers
(24, 26) back-to-back is attached to the leg (14). This holder
structure prevents a film from the liquid melt from forming
between the wafers (20, 24) when the holder is withdrawn
from the liquid growth solution, thereby eliminating the for-
mation of mesas which occur when such a film ruptures.

FIG.4

A WAFER HOLDER FOR USE IN GROWING LIQUID
PHASE EPITAXIAL FILMS ON WAFERS

The invention relates to growing liquid phase epitaxial films on semiconductor wafers and is more particularly concerned with an improved wafer holder for use in growing an epitaxial film on a wafer from a liquid phase melt.

It is an object of this invention to provide a wafer holder for use in growing such epitaxial films in which the resultant film on the wafer has substantially fewer mesa defects than has heretofore been generally achieved.

It is another object of this invention to provide a wafer holder for use in liquid phase epitaxial film growth that prevents a film from the liquid melt being formed on the wafer holder when the wafer holder is withdrawn from the liquid growth melt or solution.

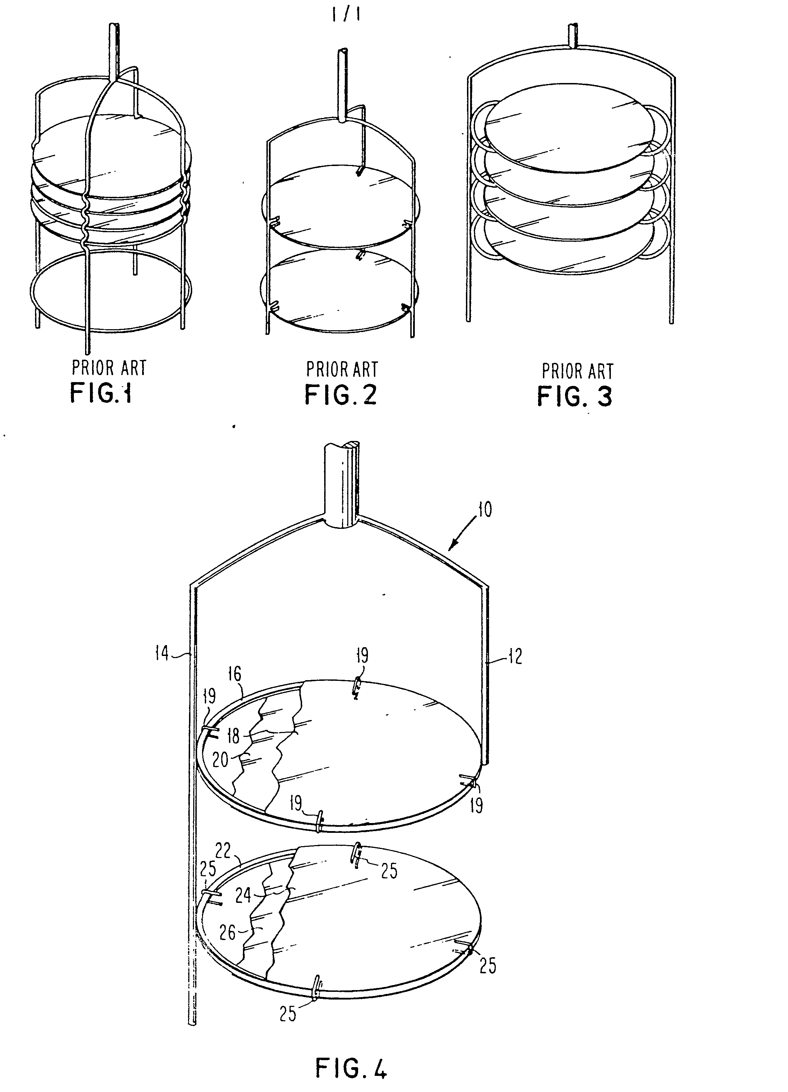

Magnetic bubble domain devices have a magnetic garnet film, for example, EuYGaFe garnet on a nonmagnetic garnet substrate, for example, $Gd_3Ga_5O_{12}$ (GGG). These films are formed by a typical standard liquid phase epitaxial (LPE) method using conventional wafer holders having two, three or four legs to support the substrates as shown in Figs. 1, 2 or 3. Typically, when growing a film on wafers by this method, a plurality of wafers which are stacked horizontally in a wafer holding means so that the spacing between the wafers is substantially the same. The wafer holder is immersed in a liquid melt and rotated so that the wafers are positioned horizontally while the film grows. After the film growth has been completed, the wafer holder is removed while maintaining the wafers in a horizontal position. The wafer holder is then rotated to spin off the excess melt from the wafers while maintaining the wafers in their horizontal position. With this approach, the method yields wafers which have a number of defects in the surface in the form of mesas. It is desirable to have as few mesa defects as possible. A mesa defect is a raised area on the wafer that occurs when a liquid droplet is not removed.

This method can also be used with pairs of wafers stacked back-to-back in the wafer holder in order to increase the throughput.  However, it has been found that the film on the bottom wafer of each wafer pair has substantially more surface defects that the film on the top wafer. As a result of the increased number of surface defects on the surface of the bottom wafer, these wafers are poor candidates for device fabrication.

One LPE approach for the growing of films on a plurality of wafers to yield films having a reduced number of mesa defects is described in U.K. specification No. 2,028,679A.  This approach involved using a wafer holder having four legs that permits the wafers to be positioned in the horizontal plane or at an angle to the horizontal plane. The liquid phase epitaxial film is grown while the wafer is in the horizontal plane.  The wafer holder is adjusted so that the wafer is tilted while the wafer is being removed from the melt.  The wafer holder is then readjusted so that the wafer is in a horizontal plane again and rotated to remove the remaining drops from the edge of the wafer.

The invention provides a wafer holder for use in growing liquid phase epitaxial films on wafers, comprising a support structure carrying a plurality of wafer-holding-means capable, in use, of holding a plurality of wafers in vertically spaced, parallel, horizontal alignment characterised in that the or each wafer-holding-means below the topmost wafer-holding-means is cantilevered out from the support structure and is secured thereto over only one small, local part of the periphery of the wafer-holding-means.

The invention will now be more particularly described with reference to the accompanying drawings, in which:-

FIGS. 1, 2 and 3 are three-dimensional views of prior art wafer holders;

FIG. 4 is a three-dimensional view of a wafer holder embodying the present invention.

A holder for liquid phase epitaxial (LPE) growth which reduces or eliminates mesas on the surface of the film is to be described. The holder has two legs to which the upper wafer supporting ring is connected. The ring has holding means so that it can hold one wafer or two wafers back-to-back. One of the two legs extends vertically below the first ring. A second ring having holding means for a pair of wafers back-to-back is attached to the elongated leg. This holder structure prevents a film from the liquid melt from forming when the holder is withdrawn from the liquid growth solution, thereby eliminating the formation of the mesas which occur when the film ruptures.

A wafer holder suitable for performing LPE film growth in accordance with the invention is shown in Figure 4. The wafer holder 10 has two legs 12 and 14. A ring 16 is connected to leg 12 and to leg 14. Wafers 18 and 20 are attached to the ring 16 by means of wire clips 19. The leg 14 extends below the ring 16 and ring 22 is connected thereto. Wafers 24 and 26 are attached to ring 22 with wire clips 25. Rings 22 and 16 are spaced so that there is about 1.5 cm spacing between wafer 20 and wafer 24.

While the wafer holder shown in Figure 4 has the leg 14 supporting two wire rings, the holder leg may support three, four or more rings. For example, when four rings are connected to the one leg, it is possible to attach four pairs of wafers making a total of eight wafers on which films are grown. The spacing between wafers or wafer pairs should be of the order of 1.5 centimeters as set forth previously.

### Example No. 1

Using the wafer holder shown in Fig. 4, two pairs of 7.62 cms (3 inch) wafers were immersed in a standard bubble garnet melt used for growing epitaxial films for three minutes and then removed. After the holder was rotated to remove the excess melt, the number of mesa defects on the surface were counted. A total of ten runs were made to form

- 4 -

epitaxial films on 40 wafers. The average number of defects per wafer
in this group of wafers was 0.5 defects. Similar data was obtained on
40 wafers using the four-legged holder shown in Fig. 1 and on 40 wafers
using the two-legged holder shown in Fig. 3. There were an average of
26 defects/wafer when the Fig. 1 holder was used and 2 defects/wafer
when the Fig. 3 holder was used.

## Example No. 2

Another series of tests were conducted in which the holders in
Figs. 1. Fig. 3 and Fig. 4 were compared. This time a visual determination was made based on a scale of 0 to 10 where "0" represents no
defects on the film surface and "10" represents a large number of
defects. In this comparison, the Fig. 4 holder had an average rating of
0.5 for 27 wafers; the Fig. 1 holder had a average rating of 7 for 31
wafers; and the Fig. 3 holder had an average rating of 2 for 9 wafers.

## Industrial Applicability

The primary advantages of the wafer holder in accordance with this
invention are that the surface of the epitaxial film formed has a small
number of defects, the holder is easy to handle, and no spacer is
required between the wafers. The wafer holder in accordance with this
invention eliminates the formation of a liquid film between wafers when
the holder is withdrawn from the melt. This film in prior art holders
subsequently breaks and splatters the wafer surfaces, thereby resulting
in mesa defects.

CLAIMS

1. A wafer holder for use in growing liquid phase epitaxial films on wafers, comprising a support structure (12, 14) carrying a plurality of wafer-holding-means (16, 19; 22, 25) capable, in use, of holding a plurality of wafers 18, 20 in vertically spaced, parallel, horizontal alignment characterised in that the or each wafer-holding-means (22, 25) below the topmost wafer-holding-means 16, 19 is cantilevered out from the support structure (14) and is secured thereto over only one small, local part of the periphery of the wafer-holding-means.

2. A wafer holder as claimed in claim 1, further characterised in that each wafer-holding-means comprises a ring having substantially the same diameter as a wafer so that only the peripheral margin of a held wafer contacts the wafer-holding-means.

3. A wafer holder as claimed in claim 2, further characterised in that the support structure comprises a first vertical rod to which each of the rings is secured.

4. A wafer holder as claimed in claim 3, further characterised in that the support structure comprises a second vertical rod, shorter than the first vertical rod, and having the topmost ring secured to its lower end so that the topmost ring is supported at two diametrically opposed positions.

5. A wafer holder as claimed in claim 2, 3 or 4, characterised in that each wafer-holding-means further comprises means for attaching two wafers in back-to-back relationship to each ring, one wafer having its film receiving surface directed upwardly and the other having its film receiving surface directed downwardly.

0026325

PRIOR ART
FIG.1

PRIOR ART
FIG.2

PRIOR ART
FIG. 3

FIG. 4

**0026325**

## European Patent Office

### EUROPEAN SEARCH REPORT

Application number

EP 80 10 5081

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| X | FUJITSU SCIENTIFIC & TECHNICAL JOURNAL, vol. 15, no. 1, March 1979 K. YAMAGUCHI et al.: "Epitaxial Growth of YSmLuCaGeIG Films with Three Micron Diameter Magnetic Bubbles", pages 69-90 <br><br> * Page 71, figure 2-b; page 73, alinea 1 * <br><br> ---- | 1-4 | C 30 B 19/06 |

**TECHNICAL FIELDS SEARCHED (Int. Cl.³)**

C 30 B 19/06

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 30-12-1980 | BRACKE |